# EUROPEAN PATENT APPLICATION

(11) **EP 4 346 004 A2**
(43) Date of publication of application: **03.04.2024**
(21) Application number: 23191621.4
(22) Date of filing: 16.08.2023
(51) Int. Cl.: H01M 50/569

(54) **CELL CONTACTING SYSTEM, METHOD FOR PRODUCING A CELL CONTACTING SYSTEM AND BATTERY MODULE**

(30) Priority: 17.08.2022 DE 102022120806
(71) Applicant: TE Connectivity Germany GmbH, 64625 Bensheim (DE)
(72) Inventor: CALLIES, Thorsten, 64625 Bensheim (DE)
(74) Representative: Patentanwaltskanzlei WILHELM & BECK

(57) **Abstract**

Cell contacting system (100) for an electrical battery module (300), comprising:
a carrier structure (101);
a multiplicity of cell contacting elements (103), arranged on the carrier structure (101), for electrical contacting of a multiplicity of battery cells (301) of the battery module (300);
a multiplicity of power connections (119) electrically connected to the cell contacting elements (103); and
a measuring arrangement (107) for measuring at least one parameter of the battery module (300) connected to the cell contacting system (100), wherein the measuring arrangement (107) comprises at least one sensor element (109) for measuring the parameter,
wherein the sensor element (109) is connected to a connection contact (115) of the cell contacting system (100) via at least one sensor line (111), wherein a monitoring device can be connected to the measuring arrangement (107) via the connection contact (115) in order to monitor the parameter, wherein the sensor element (109) is connected to at least one cell contacting element (103) and is configured to measure the parameter, and
wherein the sensor element (109) is fastened on the cell contacting element (103) via a retaining element (115) formed on the cell contacting element (103).

## Description

The invention relates to a cell contacting system for an electrical battery module, a method for producing a cell contacting system and a battery module having a cell contacting system.

Various embodiments of cell contacting systems for electrical battery modules are known from the prior art. Cell contacting systems serve to bring about the flow of current from and to the individual battery cells of the battery module. Furthermore, cell contacting systems serve to enable monitoring of parameters, such as the operating voltage and/or the operating temperature, of the battery module.

The object of the invention consists in providing an improved cell contacting system for an electrical battery module, an improved method for producing a cell contacting system and a battery module having a cell contacting system.

The object of the invention is achieved by the cell contacting system, the method for producing a cell contacting system and the battery module of the independent claims. Advantageous configurations are the subject matter of the dependent claims.

According to an aspect of the invention, a cell contacting system for an electrical battery module is provided, wherein the cell contacting system comprises:
a carrier structure;
a multiplicity of cell contacting elements, arranged on the carrier structure, for electrical contacting of a multiplicity of battery cells of the battery module;
a multiplicity of power connections electrically connected to the cell contacting elements; and
a measuring arrangement for measuring at least one parameter of the battery module connected to the cell contacting system, wherein the measuring arrangement comprises at least one sensor element for measuring the parameter, wherein the sensor element is connected to a connection contact of the cell contacting system via at least one sensor line, wherein a monitoring device can be connected to the measuring arrangement via the connection contact in order to monitor the parameter, wherein the sensor element is connected to at least one cell contacting element and is configured to measure the parameter, and wherein the sensor element is fastened on the cell contacting element via a retaining element formed on the cell contacting element.

It is thereby possible to achieve the technical advantage that an improved cell contacting system for electrical battery modules may be provided.

As a result of the measuring arrangement, a technically simple solution for measuring a parameter may be realized, by means of which the functionality and performance of the battery module may be monitored. Since the sensor elements may be wired and connected to the connection contact using standard cables, it is possible to avoid substantially more technically complex solutions, known from the prior art, which provide printed circuit boards (PCB) and ribbon cables for the electrical connection of the sensor elements and the connection contact. A technically simpler and therefore more cost-effective solution is thus enabled.

As a result of the retaining elements on the cell contacting elements, simplified contacting and fastening of the sensor elements on the cell contacting elements is enabled. As a result of the arrangement of the sensor elements on the cell contacting elements, a manufacturing process for the cell contacting system is also simplified and therefore improved.

According to an embodiment, the retaining element is designed as a clip element and is configured to clamp the sensor element on the cell contacting element.

It is thereby possible to achieve the technical advantage of enabling secure fastening of the sensor element on the cell contacting element. As a result of the clamping action, the sensor element may be securely fastened on the cell contacting elements.

Moreover, as a result of the clamping action, simple assembly of the cell contacting system may be achieved.

According to an embodiment, the retaining element defines a contacting area for contacting the sensor element, wherein the contacting area is formed at a spacing from a surface of the cell contacting element.

It is thereby possible to achieve the technical advantage that, by spacing the contacting area from the surface of the cell contacting element, the fastening of the sensor element and therefore the manufacture of the cell contacting system may be simplified.

Furthermore, differences in the thickness of the sensor line and the sensor element may be compensated via the spacing.

According to an embodiment, the retaining element defines a receiving space for receiving the sensor element, wherein the sensor element may be inserted into the receiving space in order to fasten the sensor element on the retaining element.

It is thereby possible to achieve the technical advantage that the positioning of the sensor element on the retaining element may be simplified. This in turn facilitates and simplifies the manufacturing process for the cell contacting system.

According to an embodiment, the parameter is an electrical operating voltage, wherein the sensor element is designed as an electrical contact element of the sensor line, and wherein the sensor element is fastened on the retaining element via a welded connection.

It is thereby possible to achieve the technical advantage that, with the operating voltage as a parameter, a meaningful parameter can be measured, which can be used as a basis for drawing conclusions regarding the functionality of the battery module.

Furthermore, as a result of the welded connection, robust fastening of the sensor element on the retaining element and an effective electrical connection between the two elements is enabled.

According to an embodiment, the parameter is a temperature, wherein the sensor element is designed as a temperature sensor, and wherein the sensor element is fastened on the cell contacting element in a thermally conductive manner via the retaining element.

It is thereby possible to achieve the technical advantage that a meaningful parameter can be measured via the operating temperature.

According to an embodiment, the temperature sensor is arranged on a printed circuit board, wherein a spacer element is furthermore formed on the printed circuit board, and wherein the temperature sensor is fastened on the cell contacting element by pressing the retaining element onto the spacer element.

It is thereby possible to achieve the technical advantage that, as a result of the spacer element, the temperature sensor may be securely fastened on the retaining element by clamping without the fear of damage to the temperature sensor as a result of the retaining element.

According to an embodiment, the temperature sensor is contacted by the retaining element and/or the surface of the cell contacting element in a thermally conductive manner via a bonded connection.

It is thereby possible to achieve the technical advantage of enabling further securing of the temperature sensor on the cell contacting element via the bonding. As a result of the thermal contacting, the measuring accuracy of the temperature sensor with regard to the operating temperature of the battery module may be furthermore improved.

According to an embodiment, the retaining element is formed from the cell contacting element via a punching and bending process.

It is thereby possible to achieve the technical advantage of enabling a technically simpler manufacturing process for the retaining element and, consequently, the cell contacting system.

According to a further aspect, a method for producing a cell contacting system according to one of the above embodiments is provided, comprising:
Providing a carrier element having a multiplicity of cell contacting elements, wherein at least one cell contacting element has a retaining element;
Fastening at least one sensor element of a measuring arrangement on the retaining element of the cell contacting element; and
Connecting the sensor element to a connection contact of the carrier structure via a sensor line.

It is thereby possible to achieve the technical advantage that an improved method for producing a cell contacting system having the above-mentioned technical advantages may be provided.

According to a further aspect, a battery module having a multiplicity of battery cells and a cell contacting system according to one of the above embodiments is provided.

It is thereby possible to achieve the technical advantage that an improved battery module having a cell contacting system with the above-described technical advantages may be provided.

The invention is explained in more detail below with the aid of the figures, in which:
- Figure 1: shows a schematic illustration of a cell contacting system according to an embodiment;
- Figure 2: shows a schematic illustration of a retaining element of the cell contacting system according to an embodiment;
- Figure 3: shows a schematic illustration of the retaining element in Fig. 2 with a sensor element;
- Figure 4: shows a schematic illustration of a retaining element of the cell contacting system according to a further embodiment;
- Figure 5: shows a schematic illustration of the retaining element in Fig. 4 with a sensor element;
- Figure 6: shows a schematic illustration of a retaining element of the cell contacting system according to a further embodiment with a sensor element;
- Figure 7: shows a schematic illustration of a retaining element of the cell contacting system according to a further embodiment with a sensor element;
- Figure 8: shows a schematic illustration of a sensor element, designed as a temperature sensor, according to an embodiment;
- Figure 9: shows a schematic illustration of a sensor element, designed as a temperature sensor, according to a further embodiment;
- Figure 10: shows a schematic illustration of the sensor element of Fig. 9 fastened on a retaining element;
- Figure 11: shows a further schematic illustration of the sensor element of Fig. 9 fastened on a retaining element;
- Figure 12: shows a schematic sectional side view of the sensor element of Fig. 11;
- Figure 13: shows a flow chart of a method for producing a cell contacting system; and
- Figure 14: shows a schematic illustration of a battery module having a cell contacting system.

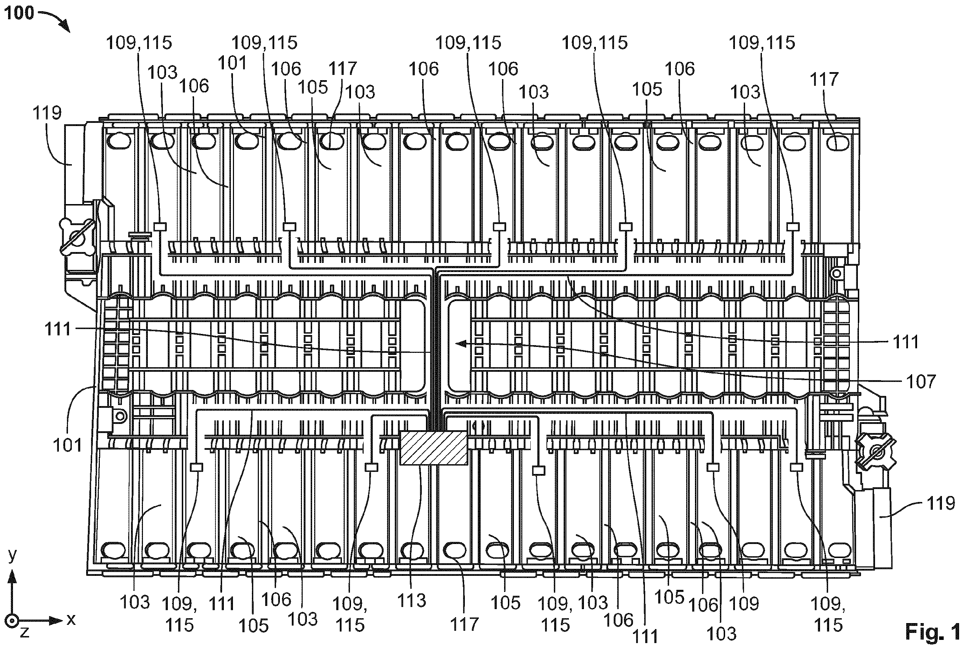

Figure 1 shows a schematic illustration of a cell contacting system 100 according to an embodiment.

In the embodiment shown, the cell contacting system 100 has a carrier structure 101 and a multiplicity of cell contacting elements 103 formed on the carrier structure 101. The carrier structure 101 is preferably made from an electrically insulating material, for example plastic.

The cell contacting elements 103 serve for electrical contacting of a multiplicity of battery cells of a battery module connected to the cell contacting system 100. The cell contacting elements 103 are made from a metal material.

The cell contacting elements 103 each have multiple cell elements 105. A cell element 105 here serves for contacting of a battery cell. The individual cell elements 105 each have connecting openings 117 for connecting and fastening the battery cells, for example via a screw connection.

The individual cell elements 105 are separated from one another in each case by separating elevations 106. The individual cell contacting elements 103 may be manufactured, for example, from sheet metal elements. The separating elevations 106 may be formed via corresponding bending or shaping processes here.

The cell contacting elements 103 are electrically connected to one another and to a multiplicity of power connections 119. A battery module connected to the cell contacting system 100 can be connected to further battery modules or to further electrical components via the power connections 119.

According to an embodiment, the cell contacting system 100 is designed for a battery module of an electric vehicle. The battery module connected to the cell contacting system 100 can therefore be connected to further components of the electric vehicle via the power connections 119.

In the embodiment shown, the cell contacting system 100 furthermore comprises a measuring arrangement 107. The measuring arrangement 107 serves for measuring a parameter of the battery module connected to the cell contacting system 100. A functionality of the battery module can therefore be monitored or checked via the measurement of the parameter.

To measure the parameter, the measuring arrangement 107 has at last one sensor element 109, which is configured to measure the parameter. To this end, the at least one sensor element 109 is connected to the respective cell contacting element 103, or fastened thereon, via a retaining element 115 formed on at least one cell contacting element 103.

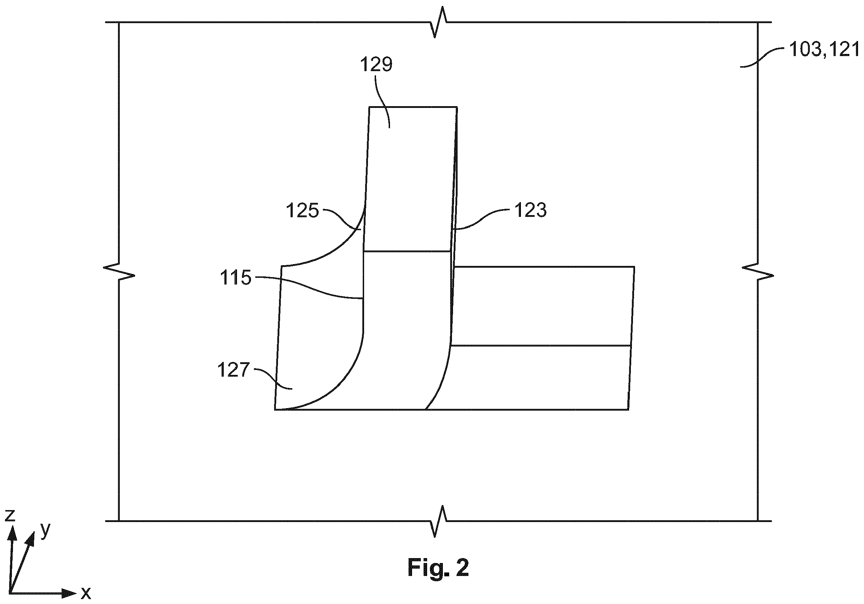

The retaining elements 115 are not shown in detail in Figure 1. For a detailed description of the retaining elements 115, please refer to the following Figures 2-12 and the associated parts of the description.

In the embodiment shown, the measuring arrangement 107 has a multiplicity of sensor elements 109. The sensor elements 109 here are each formed on the cell contacting elements 103 in such a way that only one sensor element 109 in each case is arranged on a cell contacting element 103.

The parameters to be measured may be an operating voltage or an operating temperature of the battery module. The sensor elements 109 are therefore configured to measure a voltage or temperature of the cell contacting elements 103.

In the embodiment shown, the multiple sensor elements 109 are electrically connected to a connection contact 113 via sensor lines 111. The measuring arrangement 107 and, in particular, the sensor elements 109 may be connected to a monitoring device (not shown) via the connection contact 113. The monitoring device may comprise, for example, an arithmetic unit on which software is installed, by means of which the parameters and, consequently, the functionality of the battery module connected to the cell contacting system 100 may be monitored or checked.

The sensor lines 111 may be designed as standard electrical cables.

The sensor elements 109 may be fastened to the retaining elements 115 via welded connections or bonded connections.

The number of cell contacting elements 103 of a cell contacting system 100 may be different from the number shown in Figure 1. Each cell contacting element 103 may also have a number of cell elements 105 which differs from the number shown in Figure 1. Furthermore, the measuring arrangement 107 may have any number of sensor elements 109 which differs from the number in Figure 1. The sensor elements 109 may also be formed at any points on the respective cell contacting elements 103.

Each sensor element 109 may be connected to the connection contact via an individual sensor line 111 in each case. Alternatively, multiple sensor elements 109 may be connected to the connection contact 113 via a common sensor line 111.

Figure 2 shows a schematic illustration of a retaining element 115 of the cell contacting system 100 according to an embodiment.

In the embodiment shown, the retaining element 115 comprises a bent element 125. The bent element 125 comprises a bent portion 127 and a contact portion 129 having a contacting area 123. The bent element 125 is connected to a respective cell contacting element 103 via the bent region 127.

In the embodiment shown, the retaining element 115 is manufactured from the respective cell contacting element 103 via a punching and bending process.

In the embodiment shown, the contacting area 123 is arranged at a spacing from a surface 121 of the respective cell contacting element 103. The contacting area 123 serves for the contacting of the retaining element 115 by a corresponding sensor element 109.

The contacting area 123 in the embodiment shown is arranged at a right angle to the surface 121 of the cell contacting element 103. However, the contacting area 123 may also be at any other angle to the surface 121.

In the embodiment shown, the contacting portion 129 has a cuboidal form. However, this is only illustrative. Other forms are likewise conceivable.

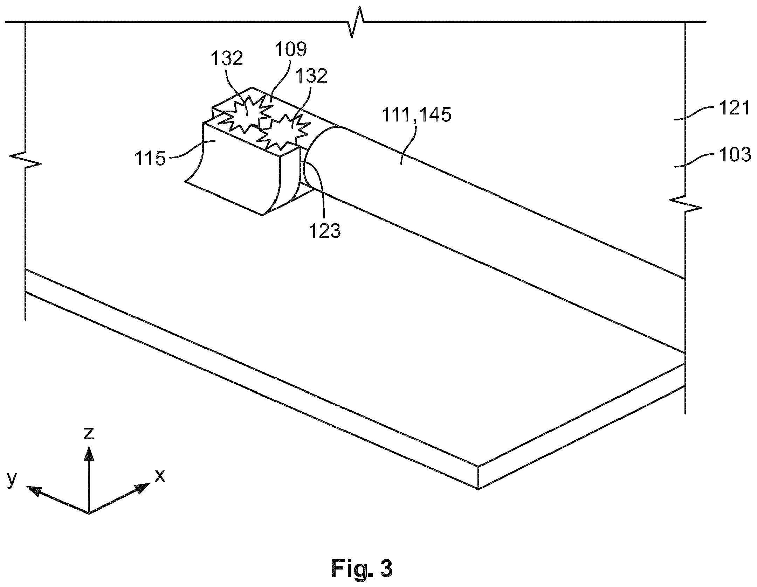

Figure 3 shows a further schematic illustration of the retaining element 115 in Fig. 2 with a sensor element 109.

In the embodiment shown, the sensor element 109 is fastened on the retaining element 115 via a welded connection 132. The sensor element 109 is arranged adjacent to the retaining element 115, with reference to the x axis of the illustrated coordinate system, and contacts the retaining element 115 via the contacting area 123.

The welded connection 132 is formed by two welded points in an upper region of the contact portion 129 of the bent element 125, with reference to the z axis.

The sensor element 109 in the embodiment shown is designed as a compacted end region of the sensor line 111. Alternatively, the sensor element 109 may be designed as a bunch of stranded wires or a cable end sleeve.

An operating voltage of a battery module connected to the cell contacting system 100 can be measured by the sensor element 109 shown, via the electrical contacting with the retaining element 115.

The sensor line 11 in the embodiment shown is designed as a commercially available electrically conductive cable with insulation 145.

As a result of the spacing of the contacting area 123 from the surface 121 of the cell contacting element 103, the sensor element 109 fastened on the contacting area 123 may likewise be arranged at a spacing from the surface 121. Differences in thickness between the sensor line 111 and the sensor element 109, which may be caused by the insulation 145, for example, may therefore be compensated.

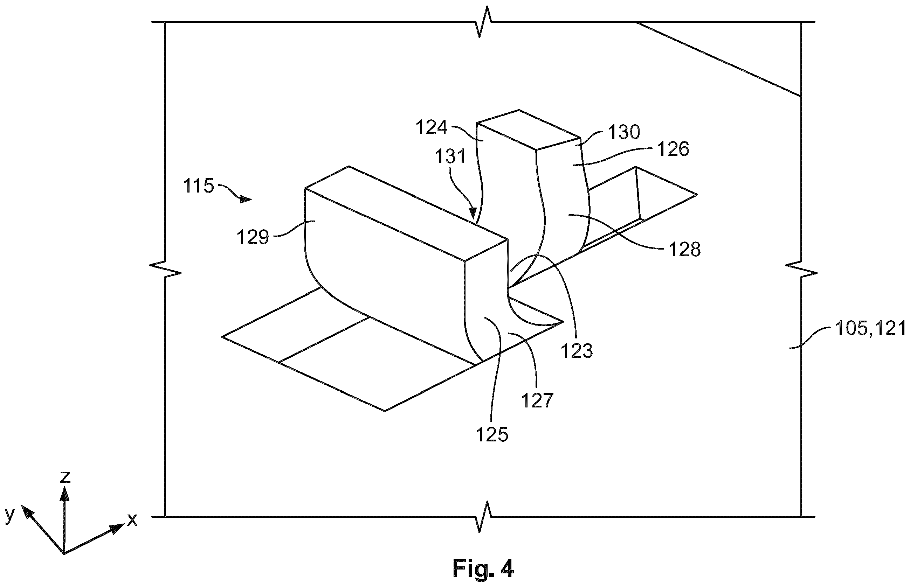

Figure 4 shows a schematic illustration of a retaining element 115 of the cell contacting system 100 according to a further embodiment.

In the embodiment shown, in addition to the bent element 125 of the embodiment in Figures 2 and 3, the retaining element 115 comprises a further bent element 126, which is arranged opposite the bent element 125 with reference to the x axis. The further bent element 126 comprises a further bent portion 128 and a further contact portion 130 having a contacting area 124.

The two contacting areas 123, 124 are arranged opposite and facing one another with reference to the x axis.

The two contacting areas 123, 124 are substantially parallel to one another and formed at a right angle to the surface 121 of the cell contacting element 103. A receiving space 131 for receiving a sensor element 109 is defined between the two bent elements 125, 126 and, in particular, between the two contacting areas 123, 124.

In the embodiment shown, both bent elements 125, 126 are formed from the cell contacting element 103 via a punching and bending process. In the embodiment shown, the further bent element 126 is formed with smaller dimensions than the bent element 125. Alternatively, both bent elements 125, 126 may have the same form and the same dimensions.

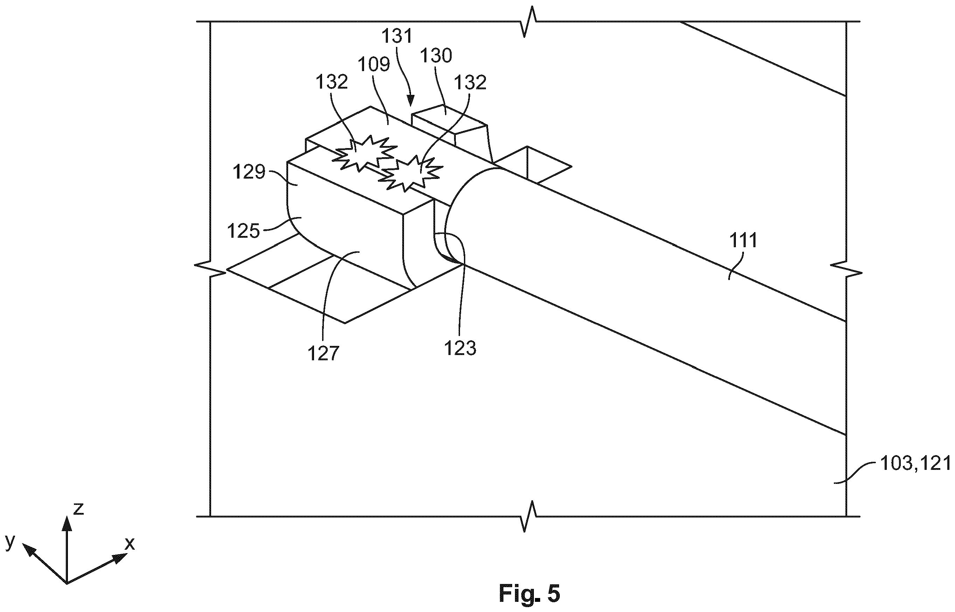

Figure 5 shows a schematic illustration of the retaining element 115 in Fig. 4 with a sensor element 109.

In Figure 5, the sensor element 109 is inserted into the receiving space 131 of the retaining element 115 and consequently electrically connected to the two contacting areas 123, 124 of the two bent elements 125, 126. The sensor element 109 is clamped in the receiving space 131 between the two contacting areas 123, 124 via the two bent elements 125, 126.

The two bent elements 125, 126 are configured to exert opposing restoring forces on the sensor element 109, which is inserted into the receiving space 131, via the bent portions 127, 128.

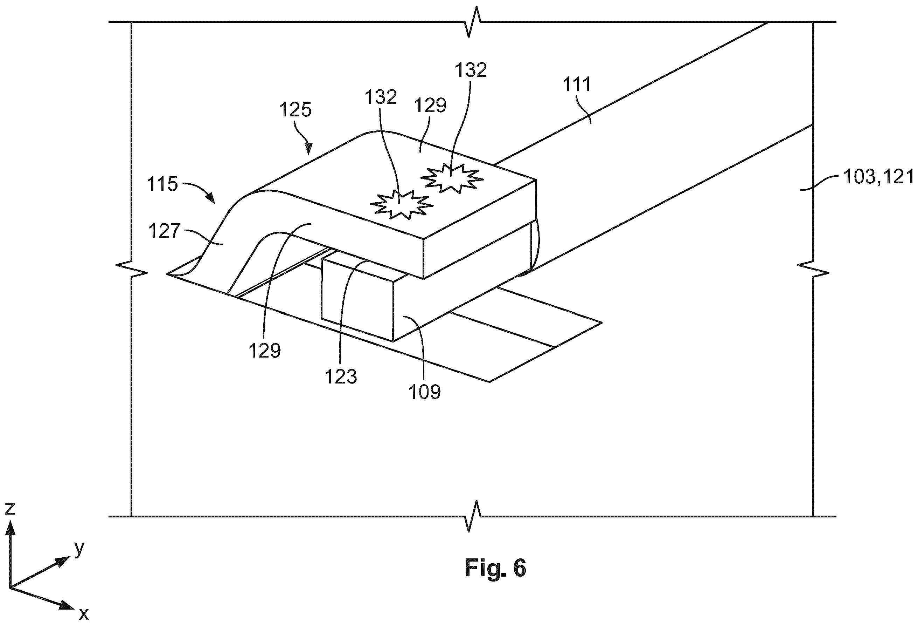

Furthermore, the sensor element is fastened on the contact portion 129 of the bent element 125 via welded connections 132, analogously to the embodiment in Figure 3. Alternatively, the sensor element 109 may be fastened on the further contact portion 130 of the further bent element 126 or on both bent elements 125, 126 via welded connections. Figure 6 shows a further schematic illustration of a retaining element 115 of the cell contacting system 100 according to a further embodiment with a sensor element 109.

In the embodiment shown, the retaining element 115 in turn comprises only one bent element 125 having a bent portion 127 and a contact portion 129 with a contacting area 123. In the embodiment shown, the contacting area 123 is arranged parallel or virtually parallel to the surface 121 of the cell contacting element 103.

The contacting area 123 is spaced from the surface 121 and facing it. A sensor element 115 is fastened on the contacting area 123 by means of a welded connection 132. The sensor element 109 is therefore arranged in a space between the surface 121 of the cell contacting element 103 and the contacting area 123.

The welded points of the welded connection 132 are formed on an area of the contact portion 129 of the bent element 125 which is arranged opposite the contacting area 123.

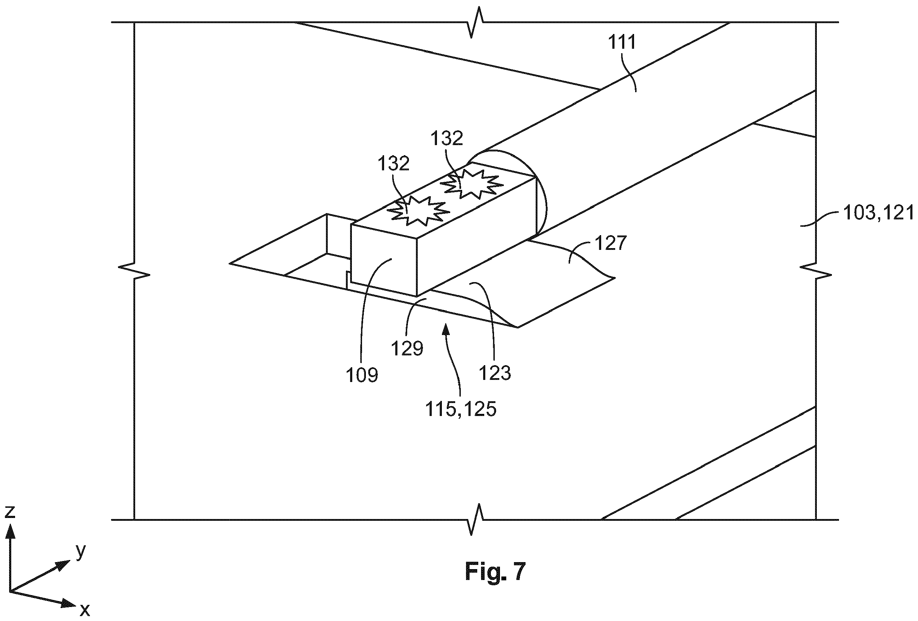

Figure 7 shows a further schematic illustration of a retaining element 115 of the cell contacting system 100 according to a further embodiment with a sensor element 109.

The embodiment shown is based on the embodiment in Figure 6. In a departure from the embodiment shown in Figure 6, in this embodiment, the contacting area 123 is in turn arranged parallel or virtually parallel to the surface 121 of the cell contacting element 103, but facing away from the surface 121. The sensor element 109 is therefore arranged such that it lies on the contacting area 123 with reference to the z axis and is fastened on the retaining element 115 via a welded connection.

Moreover, the contacting area 123 is at a smaller spacing away from the surface 121 than in the embodiment of Figure 6.

In the above-described embodiments, the contact portions each have a cuboidal form. Alternatively, other forms are also conceivable. The size and form of the contacting areas 123, 124 may vary depending on the application and design of the sensor element 109.

The sensor elements 109 in the embodiments shown are formed from compacted cuboidal portions of end pieces of the cable of the sensor line 111. Alternatively, bunches of stranded wires or cable end sleeves are likewise conceivable as sensor elements 109 for measuring the operating voltage.

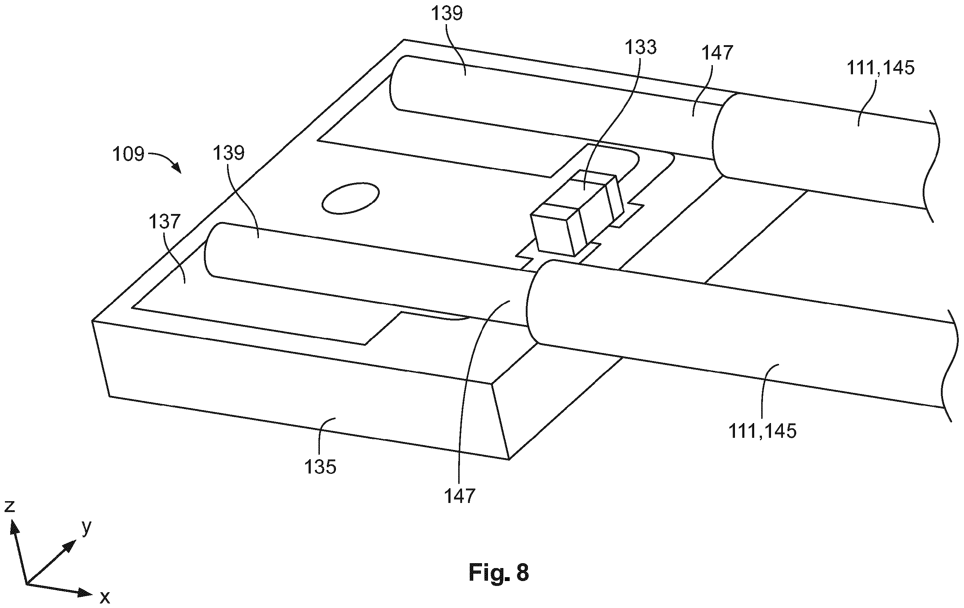

Figure 8 shows a schematic illustration of a sensor element 109, designed as a temperature sensor 133, according to an embodiment.

In the embodiment shown, the sensor element 109 comprises a temperature sensor 133 for measuring an operating temperature of a battery module connected to the cell contacting system 100.

The sensor element 109 here comprises a printed circuit board 135 with contacting fields 137 for electrically contacting the temperatures sensor 133 by means of at least one sensor line 111. In the embodiment shown, the temperature sensor 133 is electrically connected to two sensor lines 111 via the contacting fields 137.

Analogously to the above-described embodiments, the sensor lines 111 are designed as standard electrically conductive cables with insulation 145 and have connection elements 139, which, by way of example, are realised by non-insulated portions 147 and via which the sensor lines 111 are connected to the contacting fields 137 in an electrically conductive manner, for example via a soldered connection.

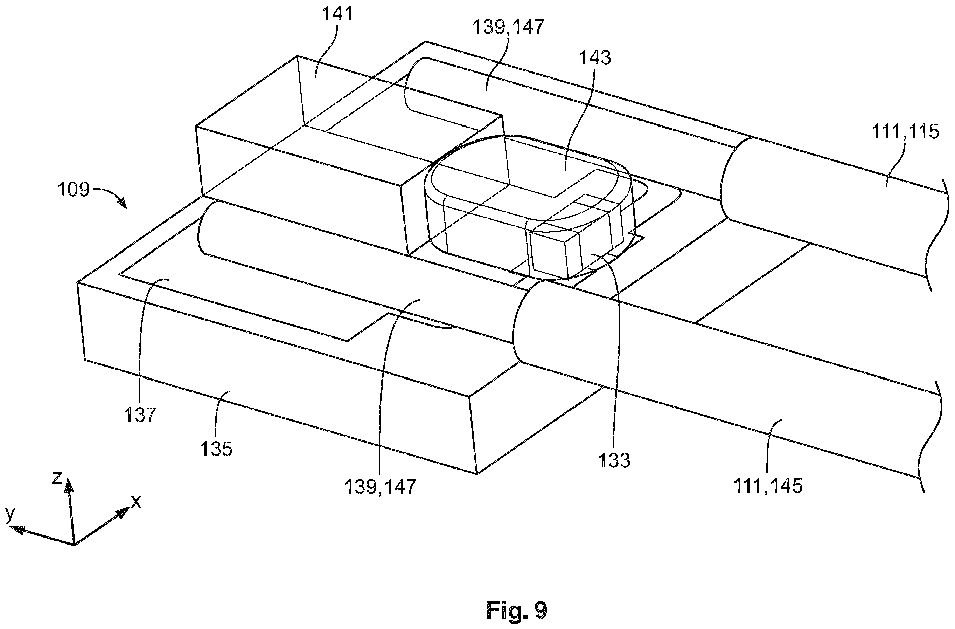

Figure 9 shows a further schematic illustration of a sensor element 109, designed as a temperature sensor 133, according to a further embodiment.

The embodiment shown is based on the embodiment in Figure 8. In the embodiment shown, a spacer element 141 is furthermore formed on the printed circuit board 135, between the two sensor lines 111. The spacer element 141 has a greater height than the temperature sensor 133 with reference to the z axis.

The spacer element 141 has a cuboidal form in the embodiment shown. Other forms are likewise possible. The dimensions of the spacer element 141 can be adapted accordingly to the requirements and designs of the temperature sensor 133. However, one prerequisite is that the spacer element 141 has a greater height than the temperature sensor 133 with reference to the z axis aligned perpendicularly to a surface of the printed circuit board 135.

In the embodiment shown, the sensor element 109 furthermore has a potting compound 143, which is arranged on the printed circuit board 135, covering the temperature sensor 133. The potting compound 143 may be formed from a potting material known from the prior art, for example from a silicone or polyurethane compound.

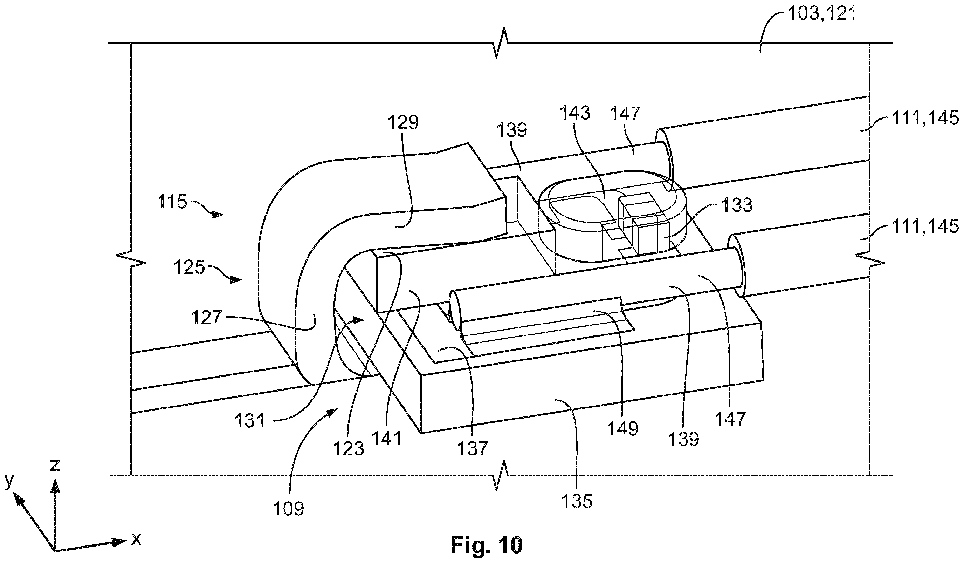

Figure 10 shows a schematic illustration of the sensor element 109 of Fig. 9, fastened on a retaining element 115.

In the embodiment shown, analogously to the above-described embodiments of Figures 6 and 7, the retaining element 115 has a bent element 125 having a bent portion 127 and a contact portion 129 with a contacting area 123. The contacting area 123 is formed parallel to the surface 121 of the cell contacting element 103 and facing the surface 121.

A receiving space 131 for receiving the sensor element 109 is defined between the surface 121 and the contacting area 123.

The sensor element 109 is inserted into the receiving space 131 in such a way that the spacer element 141 contacts the contacting area 123. Via the bent portion 127 of the bent element 125, the retaining element 115 is capable of exerting a restoring force on the spacer element 141 via the contacting portion 129 and therefore clamping the sensor element 109 in the receiving space 131 and fastening it on the retaining element 115.

In the embodiment shown, by means of soldered connections 149, the sensor lines 111 are electrically connected to the contacting fields 137 via corresponding connection portions 139, which, in the example shown, are formed by the non-insulated portions 147 of the cable.

According to an embodiment, the temperature sensor 133 may furthermore be connected to the cell contacting element 103 in a thermally conductive manner via a bonded connection (not shown). The thermal connection may be established directly via the surface 121 of the cell contacting element 103.

Alternatively or additionally, thermal contacting between the temperature sensor 133 and the retaining element 115 may occur and may be established in particular via the contacting area 123 of the contact portion 129.

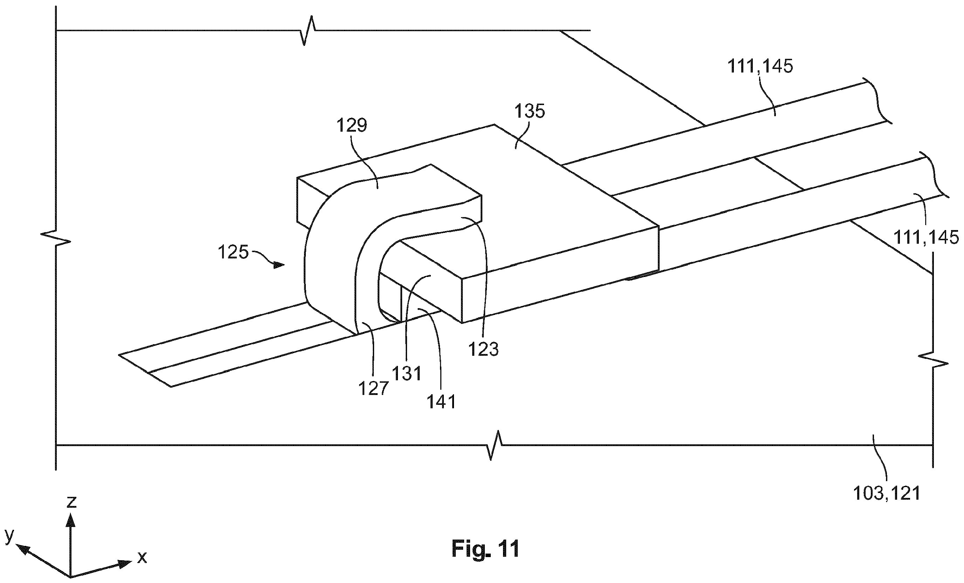

Figure 11 shows a further schematic illustration of the sensor element 109 of Fig. 9, fastened on a retaining element 115.

The embodiment shown in Figure 11 is based on the embodiment in Figure 10 and differs from this in that the sensor element 109 is arranged in a mirror-inverted manner in the receiving space 131 of the bent element 125 with reference to the z axis. An underside of the printed circuit board 135 contacts the contacting area 123 of the bent element 125 here, whilst the spacer element 141 contacts the surface 121 of the cell contacting element 103.

The clamping of the sensor element 109 in the receiving space 129 of the bent element 125 is realized analogously to the embodiment in Figure 10.

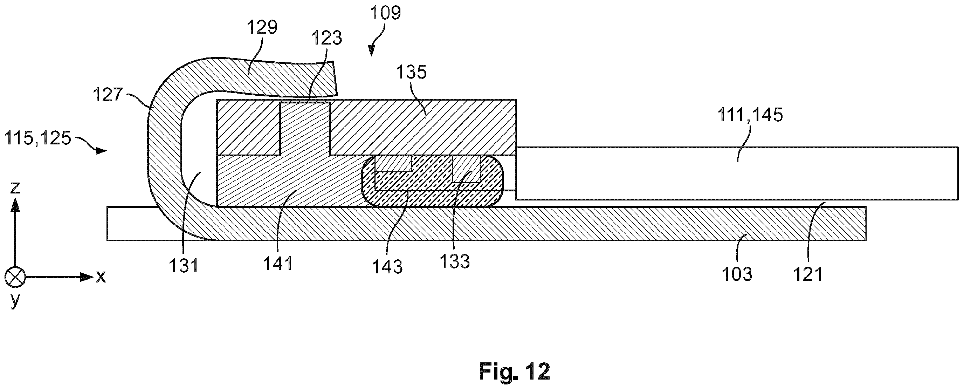

Figure 12 shows a schematic sectional side view of the sensor element 109 of Fig. 11.

It is shown in Figure 12 that the spacer element 141 extends at least partially through the printed circuit board. The spacer element 141 thereby contacts both the surface 121 of the cell contacting element 103 and the contacting area 123 of the bent element 125 or the retaining element.

The potting element 143 likewise contacts the surface 121 of the cell contacting element 103. The temperature sensor 133, on the other hand, remains at a spacing from the surface 121 of the cell contacting element 103 so that it is possible to avoid damage to the temperature sensor as a result of clamping the sensor element 109 in the receiving space 131 of the retaining element 115.

In all embodiments shown, the temperature sensor 133 may furthermore be brought into thermal contact with the cell contacting element 103 via a bonded connection (not shown).

The temperature sensor 133 may be formed for example by a thermistor.

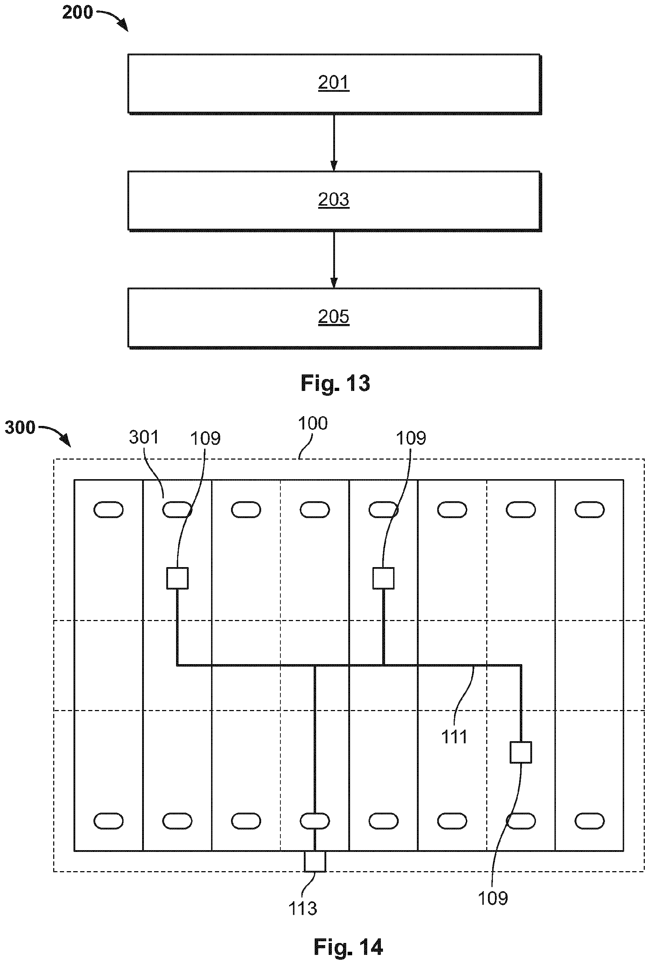

Figure 13 shows a flow chart of a method 200 for producing a cell contacting system 100.

In a first method step 201, a cell contacting system 100 according to one of the above-described embodiments is firstly provided.

The cell contacting system 100 comprises a carrier structure 100 having a multiplicity of cell contacting elements 103.

At least one retaining element 115 according to the above-described embodiments is formed on at least one cell contacting element 103.

The provision 201 of the cell contacting system 100 may therefore comprise a punching and bending process for forming the at least one retaining element 115 from the at least one cell contacting element 103.

In a further method step 203, at least one sensor element 109 is arranged on the at least one retaining element 115.

To this end, according to the above-described embodiments, the sensor element 109 may be placed on a contacting area 123 of the retaining element 115. To this end, the sensor element 109 may be positioned on the contacting area 123 or inserted into a receiving space 131 and clamped on the cell contacting element 103 by the retaining element 115.

After arranging or fastening the sensor element 109 on the retaining element 115, the sensor element 109 may be fastened on the retaining element 115, and therefore on the cell contacting element 103, via a welded connection or a bonded connection. It is thereby possible to achieve an electrical and/or thermal connection of the sensor element 109 to the cell contacting element 103.

According to the above-described embodiments, the sensor element 109 may be designed to measure an operating voltage of a battery module connected to the cell contacting system 100.

Alternatively, the sensor element 109 may be configured to measure an operating temperature of the battery module. To this end, the sensor element 109 may comprise a temperature sensor 133 according to the above-described embodiments.

In a further method step 205, the at least one sensor element 109 arranged or fastened on the retaining element 115 may be electrically connected to a connection contact 113 via a sensor line 111.

The sensor line 111 here may be realized by a standard and commercially available electrical cable.

The connection contact 113 formed on the carrier structure 101 enables electrical connection of a monitoring device to the cell contacting system 100. The monitoring device is designed to monitor the parameters of the battery module which are described by the operating voltage and/or the operating current.

The monitoring device may comprise a corresponding arithmetic unit, for example, on which corresponding software is installed for monitoring and evaluating the parameter.

Figure 14 shows a schematic illustration of a battery module 300 having a cell contacting system 100.

The battery module 300 comprises a multiplicity of battery cells 301. The cell contacting system 100 is electrically connected to the multiplicity of battery cells 301 via the multiplicity of cell contacting elements 103. The connection may be achieved, for example, via screw connections through the connecting openings 117 of the cell contacting elements 103. The cell contacting system 100 furthermore has a measuring arrangement 107 having a multiplicity of sensor elements 109 arranged on the cell contacting elements 103 in order to measure a parameter of the battery module 300. The sensor elements 109 are connected to a connection contact 113 via sensor lines 111.

The individual battery cells 301 of the battery module 300 are connected to one another via the cell contacting elements 103 of the cell contacting system 100. The battery cells 301 may be connected to one another both in series and in parallel via the cell contacting system 100.

The battery module 300 may be designed, in particular, as a battery module 300 for an electric vehicle.

### List of reference symbols

- 100: Cell contacting system
- 101: Carrier structure
- 103: Cell contacting element
- 105: Cell element
- 106: Separating elevation
- 107: Measuring arrangement
- 109: Sensor element
- 111: Sensor line
- 113: Connection contact
- 115: Retaining element
- 117: Connecting opening
- 119: Power connection
- 121: Surface
- 123: Contacting area
- 124: Further contacting area
- 125: Bent element
- 126: Further bent element
- 127: Bent portion
- 128: Further bent portion
- 129: Contact portion
- 130: Further contact portion
- 131: Receiving space
- 132: Welded connection
- 133: Thermistor
- 135: Printed circuit board
- 137: Contacting field
- 139: Connection element
- 141: Spacer element
- 143: Potting compound
- 145: Insulation
- 147: Non-insulated portion
- 149: Soldered connection

- 200: Method
- 201: Providing a carrier element
- 203: Fastening a sensor element
- 205: Connecting the sensor element

- 300: Battery module
- 301: Battery cell

## Claims

1. Cell contacting system (100) for an electrical battery module (300), comprising:
a carrier structure (101);
a multiplicity of cell contacting elements (103), arranged on the carrier structure (101), for electrical contacting of a multiplicity of battery cells (301) of the battery module (300);
a multiplicity of power connections (119) electrically connected to the cell contacting elements (103); and
a measuring arrangement (107) for measuring at least one parameter of the battery module (300) connected to the cell contacting system (100), wherein the measuring arrangement (107) comprises at least one sensor element (109) for measuring the parameter, wherein the sensor element (109) is connected to a connection contact (115) of the cell contacting system (100) via at least one sensor line (111), wherein a monitoring device can be connected to the measuring arrangement (107) via the connection contact (115) in order to monitor the parameter, wherein the sensor element (109) is connected to at least one cell contacting element (103) and is configured to measure the parameter, and wherein the sensor element (109) is fastened on the cell contacting element (103) via a retaining element (115) formed on the cell contacting element (103).

2. Cell contacting system (100) according to Claim 1, wherein the retaining element (115) is designed as a clip element and is configured to clamp the sensor element (109) on the cell contacting element (103).

3. Cell contacting system (100) according to Claim 1 or 2, wherein the retaining element (115) defines a contacting area (123) for contacting the sensor element (109), and wherein the contacting area (123) is formed at a spacing from a surface (121) of the cell contacting element (103).

4. Cell contacting system (100) according to one of the preceding claims, wherein the retaining element (115) defines a receiving space (131) for receiving the sensor element (109), and wherein the sensor element (109) may be inserted into the receiving space (131) in order to fasten the sensor element (109) on the retaining element (115).

5. Cell contacting system (100) according to one of the preceding claims, wherein the parameter is an electrical voltage or an electrical current, wherein the sensor element (109) is designed as an electrical contact element of the sensor line(111), and wherein the sensor element (109) is fastened on the retaining element (115) via a welded connection (132).

6. Cell contacting system (100) according to one of the preceding claims, wherein the parameter is a temperature, wherein the sensor element (109) is designed as temperature sensor, and wherein the sensor element (109) is fastened on the cell contacting element (103) in a thermally conductive manner via the retaining element (115).

7. Cell contacting system (100) according to Claim 6, wherein the temperature sensor (133) is arranged on a printed circuit board (135), wherein a spacer element (141) is furthermore formed on the printed circuit board (135), and wherein the temperature sensor (133) is fastened on the cell contacting element (103) by pressing the retaining element (115) onto the spacer element (141).

8. Cell contacting system (100) according to Claim 6 or 7, wherein the temperature sensor (133) is contacted by the retaining element (115) and/or the surface (121) of the cell contacting element (103) in a thermally conductive manner via a bonded connection.

9. Cell contacting system (100) according to one of the preceding claims, wherein the retaining element (115) is formed from the cell contacting element (103) via a punching and bending process.

10. Method (200) for producing a cell contacting system (100) according to one of the preceding claims 1 to 9, comprising:
Providing (201) a carrier structure (101) having a multiplicity of cell contacting elements (103), wherein at least one cell contacting element (103) has a retaining element (115);
Fastening (203) at least one sensor element (109) of a measuring arrangement (107) on the retaining element (115) of the cell contacting element (103); and Connecting (205) the sensor element (109) to a connection contact (115) of the carrier structure (101) via a sensor line (111).

11. Battery module (300) having a multiplicity of battery cells (301) and a cell contacting system (100) according to one of the preceding claims 1 to 9.
